# EUROPEAN PATENT APPLICATION

(11) **EP 0 992 973 A2**
(43) Date of publication of application: **12.04.2000**
(21) Application number: 99660157.1
(22) Date of filing: 05.10.1999
(51) Int. Cl.: G10K 11/00

(54) **Method for attaching an acoustic transducer to a substrate**

(30) Priority: 05.10.1998 FI 982156
(71) Applicant: NOKIA MOBILE PHONES LTD., 02150 Espoo (FI)
(72) Inventor: Hietanen, Jarmo, 33580 Tampere (FI)
(74) Representative: Pursiainen, Timo Pekka

(57) **Abstract**

The invention relates to a method in connection with an acoustic transducer, such as a microphone (1), for a communication device, such as a wireless communication device (4), in which method the acoustic transducer (1) is attached on a substrate (2), such as a circuit board, or integrated in the substrate (2), and the housing (5) of the communication device is formed of at least a first (5a) and a second part (5b). The substrate (2) is provided with one or more apertures (3a-3f), which partly surround the acoustic transducer (1) order to achieve a nearly floating attachment for the acoustic transducer (1).

## Description

The present invention relates to a method in connection with an acoustic transducer, such as a microphone, of a communication device, such as a wireless communication device, in which method the acoustic transducer is fixed on a substrate, such as a circuit board, or is formed as a part of the substrate, and the housing of the communication device is composed of at least a first part and a second part. The invention also relates to a communication device, such as a wireless communication device, in which an acoustic transducer, such as a microphone, is attached on a substrate, such as a circuit board, or formed as a part of the substrate, and the housing of the communication device is composed of at least a first and a second part.

In this specification, acoustic transducers refer to means with which an acoustic signal is converted into an electric signal (microphones), and correspondingly, an electric signal is converted into an acoustic signal (speakers, receivers, buzzers).

Microphones can be divided into different types according to the operating principle. The most commonly used microphone types are based on an electrostatic or electromagnetic (a moving reel or magnet) principle, or to the piezoelectric phenomenon. For example in known electrostatic microphones, it is possible to use for example two advantageously planar diaphragms or boards, located in the vicinity of each other and forming a capacitor, as transducer means for converting an acoustic signal into an electric signal. The first diaphragm is typically elastic or flexible, and the second diaphragm is made substantially stationary. The conversion is based on a change in the capacitance between the transducer means, which is the outcome of an alteration in the distance between the diaphragms. The force between the diaphragms depends, for instance, on electric charges prevailing in the diaphragms, and on other mechanical structures. In microphones, sound creates deformations in an acoustic means, which deformations are coupled into an electric signal e.g. according to the physical principle presented above.

In wireless communication devices, it is common to use a microphone capsule, which is attached for example on a circuit board used as a substrate for the microphone. Also, solutions have been developed, in which the microphone constitutes a part of the circuit board. The circuit board also contains other electronics of the wireless communication device. The circuit board is fixed in the housing of the wireless communication device, which housing is typically made of a relatively hard and rigid plastic material. Consequently, the microphone, the circuit board or circuit boards with their other components, and the housing of the device create a practicable device unit.

In the circuit board functioning as a substrate for the microphone, mechanical stresses develop, which are partly a result of fixing the circuit board in the housing. The housing of the wireless communication device can also be subjected to mechanical forces for various reasons. One factor that produces mechanical stresses is variations in temperature which result from variations in the temperature of the environment and also from the fact that during use the device heats up to a certain extent. Thus, it is possible that strong mechanical stress states develop both in the housing and in the circuit board. These mechanical stresses and the changes in them produce various audio frequency vibrations in the housing and in the circuit board. In devices of prior art, such vibrations are easily transmitted via the housing and the circuit board also to the acoustic transducer means of the microphone, thus producing spurious signals. During the use of the device, the communication device may also be subjected to other mechanical forces. For example, when a mobile station is held in the hand, it is possible that the changes in the pressing force and the movements of the fingers are easily heard in the receiving end of the call on the basis of the aforementioned mechanism. However, the user him/herself does not necessarily notice that such interference noise is generated and transmitted to the receiving end.

It is very difficult and expensive to remove the above-described spurious signals from an electric signal. Due to the firm mechanical coupling of the housing and the circuit board, interference noise can pass to the microphone structure. Furthermore, when taking into account that the housing and especially the circuit board transmit the aforementioned interference noise without substantial attenuation, the interference noise passed to the microphone itself is loud and the electric signal produced thereby can be even stronger than the electric signal produced by speech in the microphone. It is possible to make an attempt to attenuate such side tones by placing an intermediate plate, for example a piece of foamed plastic or a piece of soft rubber, between the microphone and the microphone substrate to suppress the vibration. This, however, increases the work required in the installation as well as the manufacturing costs of the device. Furthermore, this solution is not suitable in connection with a microphone integrated in the circuit board.

The purpose of the present invention is to provide a fixing method with which it is possible to consirerably attenuate mechanical vibrations transmitted to an acoustic transducer via a circuit board and the housing of a communication device. The invention is based on the idea that the substrate of the acoustic transducer is provided with apertures cutting stress states and the travel paths of the sound in the immediate proximity of the fixing point of the acoustic transducer, and on the other hand, that it is possible to produce the housing at least partly with a multiplastic technique, in which the part of the housing which faces the surface of the substrate, is in the vicinity of the acoustic transducer at least to a certain extent made of a plastic material that is elastic. The method according to the present invention is characterized in that the substrate is provided with one or more apertures with which the acoustic transducer is partly encircled to attain an almost floating attachment for the acoustic transducer. The communication device according to the present invention is characterized in that the substrate is provided with one or more apertures, with which the acoustic transducer is arranged to be partly encircled to attain an almost floating attachment for the acoustic transducer.

With the present invention, considerable advantages are achieved when compared with solutions of prior art. By means of a structure composed according to the invention, it is possible to significantly reduce the access of mechanical vibrations, transmitted via the housing and the circuit board, to the microphone, wherein the amount of interference noise converted by the microphone into an electric signal can be reduced. Thus, the quality of the speech is improved in the receiving end. Furthermore, the interference noise produced in the device by the user is not so strongly transmitted to the receiving end as in the case of using structures of prior art. The solution according to a preferred embodiment of the invention makes it also possible to reduce the size of the device, because separate attenuators are not required for the microphone structure and, on the other hand, it is not necessary to use separate sealing and attenuation means in connection with the microphone.

In the following, the invention will be described in more detail with reference to the appended drawings, in which:
- Fig. 1a: shows a top-view on a structure according to a first preferred embodiment of the invention implemented on a circuit board,
- Fig. 1b: shows a first part of the housing of a wireless communication device in a perspective view,
- Fig. 1c: shows a second part of the housing of a wireless communication device in a perspective view,
- Fig. 1d: shows the placement of the structure according to Fig. 1a in the housing of a wireless communication device according to Figs. 1 b and 1 c in a reduced cross-section at A-A,
- Fig. 2a: shows a top-view on a solution according to a second preferred embodiment of the invention when established on a circuit board, and
- Fig. 2b: shows the placement of the structure according to Fig. 2a in the housing of a wireless communication device in a cross-section at B-B.

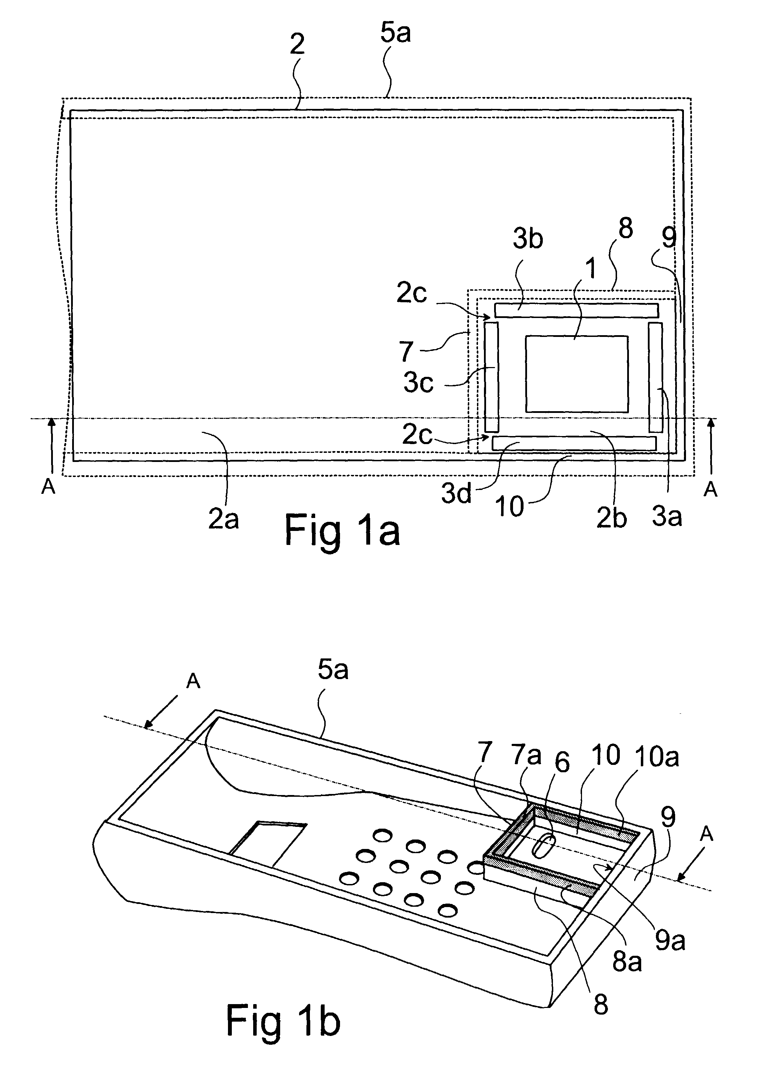

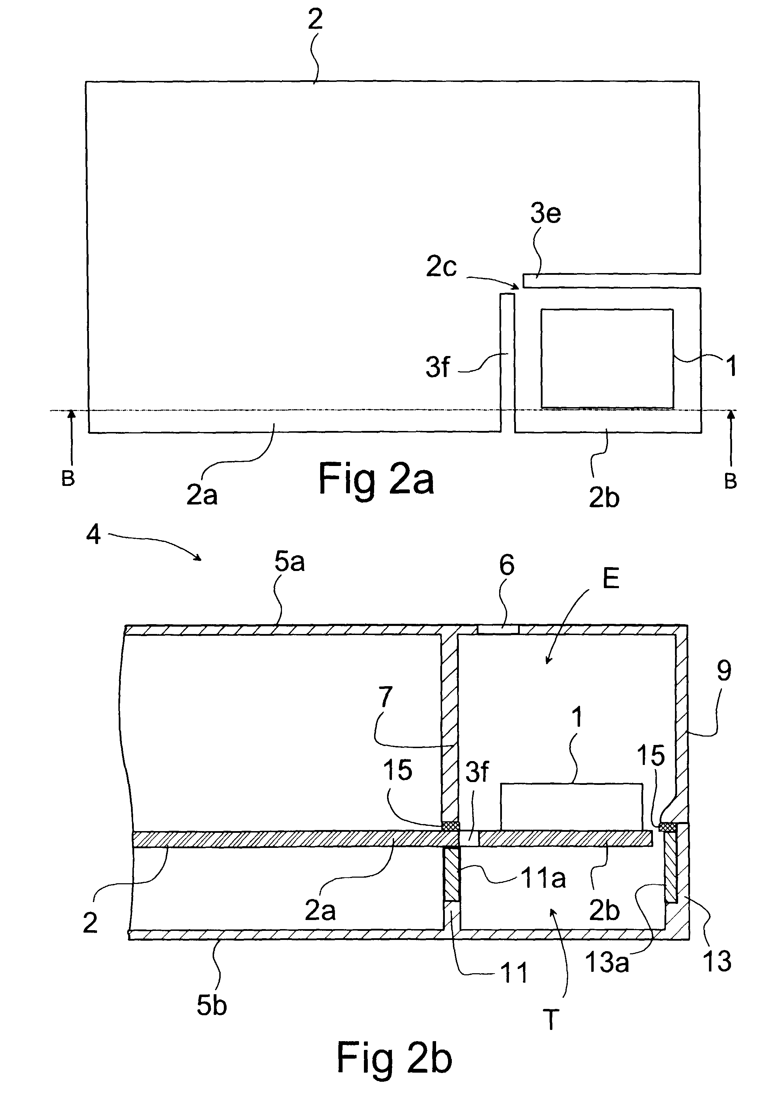

In Fig. 1a, the substrate used for the microphone 1 is a circuit board 2. The circuit board 2 is provided with apertures 3a-3d in the vicinity of the attachment point of the microphone 1. These apertures 3a-3d are in this example formed in a substantially rectangular shape, but it is obvious that other shapes can be used as well. The apertures can be formed for example by boring holes next to each other. Even though two (Fig. 2a) or four (Fig. 1a) apertures are used in the structures presented in this specification, it is also possible within the scope of the invention that there are one, three, or more than four of these apertures. The apertures 3a-3d provide an almost floating structure for the attachment of the microphone 1. In Fig. 1a, dashed lines illustrate the location of a housing 5 with respect to the circuit board 2, when the circuit board is positioned in the housing 5. The microphone 1 is advantageously a non-encapsulated microphone, a surface-mounted microphone, or it is integrated in the circuit board.

Fig. 1b presents, in a perspective view, a preferred first part 5a for the housing 5 of a wireless communication device, of which part only the features essential for the description of the invention are presented. In this example, the first part 5a of the housing is a so-called A-cover for a mobile phone, provided with apertures for the display and keys.

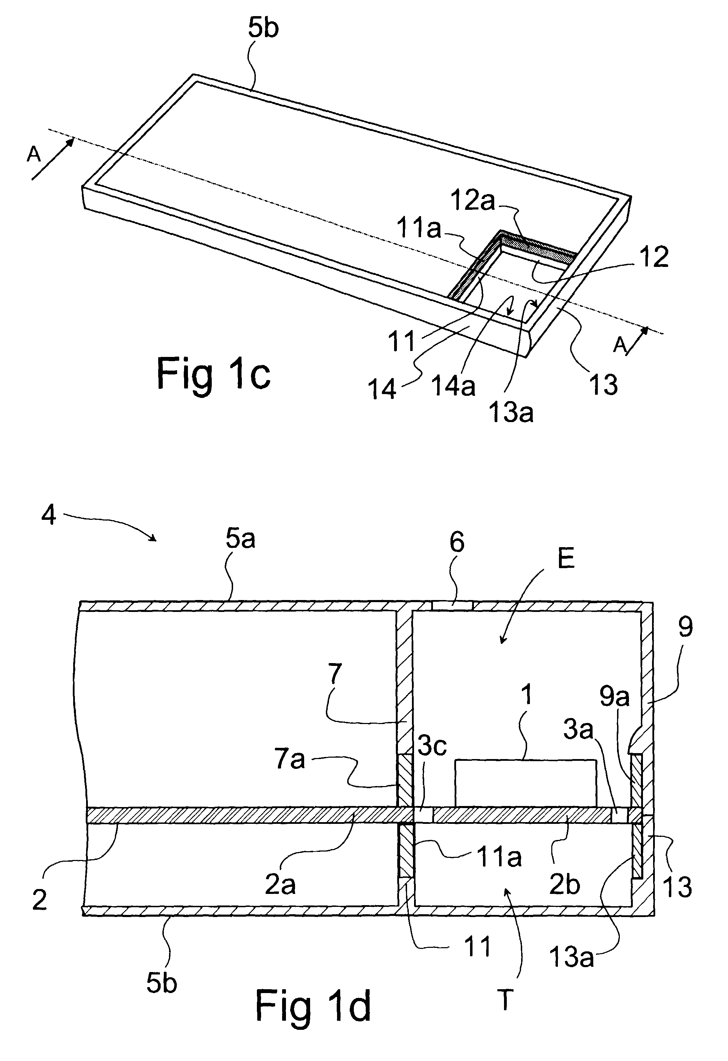

Correspondingly, Fig. 1c presents, in a perspective view, a preferred second part 5b for the housing of a wireless communication device, showing only the features essential with respect to the invention. In this example, the second part 5a of the housing is a so-called intermediate cover, which can also function as a bottom part for the housing.

Fig. 1d presents in a cross-section at A-A the placement of a circuit board 2 according to Fig. 1a in the housing 5 of a wireless communication device 4. In Figs. 1a, 1b and 1c, the point of cross-section is marked with a line of dots and dashes. In the housing 5, advantageously in the first part 5a, an acoustic arrangement is established for the microphone. In this preferred embodiment, the acoustic arrangement is composed of a sound channel 6 and walls 7, 8, 9, 10 provided in the first part 5a of the housing (Fig. 1b). Variations in the air pressure which are developed by sound, are passed from the sound channel 6 to a front volume E enclosed by the housing 5a, the walls 7, 8, 9, 10 and the circuit board 2. Furhermore, variations in air pressure are passed via apertures 3a-3d also to a back volume T located on the other side of the circuit board part 2a used as the microphone substrate, the back volume T being enclosed by the circuit board 2 and the second part 5b of the housing and the walls 11, 12, 13, 14 of the same (Fig. 1c). Variations in the air pressure generate an electric signal in the microphone 1, which signal amplified and transmitted forward, as is known per se. The acoustic features of the microphone structure are affected by the sound channel 6, by said volumes E, T, and by the apertures 3a-3d connecting them.

Mechanical vibrations developed by the stress states of the circuit board and other mechanical vibrations transmitted via the circuit board are, however, not to a significant degree mechanically coupled past the apertures 3a-3d provided around the microphone 1. The vibrations will be significantly attenuated due to these apertures 3a-3d provided around the microphone 1. Only such an amount of circuit board material is provided between the apertures that the part 2b of the circuit board used as the assembling substrate remains attached to the rest of the circuit board 2a in normal operating situations. However, mechanical vibrations will not be propagated significantly past these attachment areas 2c, whereby the microphone 1 is not subjected to strong mechanical vibrations. If necessary, the attachment areas can also be used for circuitry e.g. to couple the microphone electrically to other electronics, but separate connection leads can also be used. The apertures 3a-3d are arranged on the circuit board 2 in such a way that at least some of the apertures 3a-3d are at least partly located within the area on the circuit board 2 which is defined by the walls 7, 8, 9, 10 which form the acoustic arrangement. The second part 5b of the housing is provided with one or more second walls 11, 12, 13, 14, placed substantially by the wall 7, 8, 9, 10 of the first part, wherein the circuit board 2 is located between at least one said wall 7, 8, 9, 10 of the first part and at least one said wall 11, 12, 13, 14 of the second part. Consequently, when the circuit board 2 is installed in the housing 5, at least one wall 7, 8, 9, 10 of the first part 5a in the housing and at least one wall 11, 12, 13, 14 of the second part 5b is pressed against the circuit board 2, which further attenuates the vibrations transmitted via the circuit board 2 to the microphone 1.

The housing 5 of the wireless communication device can be partly composed by using a so-called multiplastic technique. The walls 7, 8, 9, 10 of the first part 5a of the housing are made of a softer plastic material than for example the outer surface of the housing 5. These parts, which are marked in the appended drawings with reference numbers 7a, 8a, 9a and 10a, and darkened in Figs. 1b and 1c for the sake of clarity, support the circuit board 2 in the vicinity of the apertures 3a-3d arranged in the circuit board. Corresponding softer areas are preferably also made in the walls 11, 12, 13, 14 of the second part 5b of the housing, and they are marked in the drawings with reference numbers 11a, 12a, 13a, 14a. Vibrations, caused by mechanical forces acting upon the housing 5, will be significantly dampened by the softer plastic material of these softenings, whereby vibration sounds are not transmitted via the circuit board 2 to the microphone 1. In prior art solutions, the entire housing is, however, made of rigid plastic, which easily transfers spurious noise to the circuit board 2 which is used as the microphone substrate, and via this to the microphone 1 itself. Another advantage achieved with this multiplastic technique is that the parts of the walls which come against the surface of the circuit board function also as a sealing for the acoustic arrangement, excluding the acoustically controlled sound channels 6, wherein separate seal rings or the like are not necessary. This also reduces the number of parts and work stages required in the manufacture of a wireless communication device.

Fig. 2a presents a second preferred embodiment of the invention, provided with two groove-like apertures 3e, 3f. That part 2b of the circuit board in which the microphone 1 is located is attached to the remaining part 2a of the circuit board merely by means of a narrow attachment strip 2c. Also with this solution, the mechanical vibrations transmitted via the circuit board 2 can be significantly attenuated before they are conducted to the microphone 1.

Fig. 2b presents, in a cross-section, the placement of a circuit board according to Fig. 2a in the housing 5 of a wireless communication device 4. In this example, the first part 5a of the housing is made of a single plastic material, wherein a sealing means 15, such as a seal ring, is placed in between the intermediate walls 7, 8. The second part 5b of the housing is, however, produced with the multiplastic technique, wherein the walls 11, 12 are provided with parts made of softer plastic.

The structure of the housing 5 corresponds in other respects to the requirements of the application used in a given situation, for example as presented in Figs 1 b and 1 c.

With the method according to the invention, the substrate structure for the microphone 1 can be made as floating as possible, wherein the effect of mechanical stresses and other interference factors causing mechanical vibrations can be reduced to the minimum.

In practical applications, the fixing structures of an acoustic transducer according to the invention will resonate to a certain degree in a particular frequency range determined by the mass of the floating structure (the microphone element and the bottom plate) and by the elasticity of the bottom plate. This mechanical resonance can be further attenuated for example in such a way that the apertures 3a-3d; 3e, 3f are filled either entirely or partly with mechanically absorbing material, for example with soft plastic. Another advantageous alternative is to place attenuating material, such as attenuation gel, in the back volume in between the circuit board part 2b used as the substrate and the bottom formed by the second part 5b of the housing. In an application, where the microphone 1 is integrated in the circuit board, the circuit board 2 contains one or more apertures (not shown) near the microphone structure. In this case, the attenuation gel has to be placed in such a way that it does not cover these apertures of the microphone structure. The mechanical point of resonance in the attachment structure can be tuned to such a frequency that it does not affect the conversion of audio signals to an electric signal. The resonance can be influenced for instance by the dimensioning and the number of attachment points 2c and apertures 3a-3d; 3e, 3f. Furthermore, the effect of mechanical resonace can be compensated electrically with filters and other solutions known as such.

Even though the invention has been described above primarily in connection with microphones using a circuit board as the substrate for a microphone, the invention can also be applied to other acoustic transducers. Furthermore, it is possible to replace the circuit board as the assembling substrate for an acoustic transducer with another suitable substrate that is provided with apertures to attenuate and modify mechanical vibrations.

The method and microphone structure according to the invention can be advantageously applied in wireless communication devices, such as mobile phones, communication devices, portable computers in connection with which wireless communication devices are used to connect to a mobile communication network or the like, etc. Advantageous applications that can be mentioned in this context include the GSM mobile stations in the GSM cellular network, the mobile stations in the UMTS cellular network, and the mobile stations in the DCT cellular network, but it is obvious that the present invention can also be applied in other communication devices. For example, a portable computer (not shown) can contain built-in wireless data transmission means and a microphone which is attached on or integrated in a circuit board. The circuit board is provided with two or more apertures by means of which mechanical vibrations are attenuated. Furthermore, the housing of the computer is provided with an acoustic arrangement, in which one or more walls constituting the arrangement are formed by means of the multiplastic technique, following the principles of above-presented examples. A second alternative for a wireless communication device implemented with a computer is to connect to the computer a so-called card phone (not shown) which contains data transmission means and a microphone structure implemented according to the present invention

The present invention is not restricted solely to the embodiments presented above, but it can be modified within the scope of the appended claims.

## Claims

1. A method in connection with an acoustic transducer, such as a microphone (1), for a communication device, such as a wireless communication device (4), in which method the acoustic transducer (1) is attached to a substrate (2), such as a circuit board, or integrated in the substrate (2), and the housing (5) of the communication device is formed of at least a first (5a) and a second part (5b), **characterized** in that the substrate (2) is provided with one or more apertures (3a-3f), partly surrounding the acoustic transducer (1) in order to achieve an almost floating attachment for the acoustic transducer (1).

2. The method according to claim 1, in which the housing (5) comprises an acoustic arrangement for the acoustic transducer (1), **characterized** in that the acoustic arrangement is formed by one or more walls (7-10) produced by means of a multiplastic technique.

3. The method according to claim 2, **characterized** in that the apertures are arranged in the substrate (2) in such a way that at least some of the apertures are at least partly in the area of the substrate (2) defined by the walls constituting the acoustic arrangement.

4. A communication device (4), such as a wireless communication device, in which an acoustic transducer (1), such as a microphone (1), is attached to a substrate (2), such as a circuit board, or integrated in the substrate (2), and the housing (5) of the communication device is formed of at least a first (5a) and a second part (5b), **characterized** in that the substrate (2) is provided with one or more apertures (3a-3f) partly surrounding the acoustic transducer (1) in order to achieve an almost floating attachment for the acoustic transducer (1).

5. A communication device (4) according to claim 4, which comprises an acoustic arrangement established for the acoustic transducer (1) in the housing (5), **characterized** in that the acoustic arrangement is composed of one or more walls (7-10) produced by means of multiplastic technique.

6. The communication device (4) according to claim 5, **characterized** in that the apertures are arranged in the substrate (2) in such a way that at least some of the apertures (3a-3f) are at least partly in the area of the substrate (2) defined by the walls (7-10) constituting the acoustic arrangement.

7. The communication device (4) according to claims 5 or 6, **characterized** in that the part of said walls (7-10) which is arranged to be pressed against the surface of the substrate (2) when the substrate is fixed in the housing, is made of softer plastic than the remainder of said walls (7-10).

8. The communication device (4) according to claim 5, **characterized** in that said walls (7-10) constituting the acoustic arrangement are formed in the first part of the housing, and that one or more second walls (11-14) are formed in the second part (5b) of the housing, sustantially near the wall (7-10) of the first part, wherein the substrate (2) is located between at least one wall (7-10) of said first part and at least one wall (11-14) of said second part.

9. The communication device (4) according to claim 5, **characterized** in that it is a GSM mobile station.

10. The communication device (4) according to any of the claims 4 to 9, **characterized** in that the acoustic transducer (1) is a non-encapsulated microphone.
